**Europäisches Patentamt**

**European Patent Office**

**Office européen des brevets**

(19)

(11) **EP 0 758 127 B1**

(12) ## EUROPEAN PATENT SPECIFICATION

(45) Date of publication and mention
of the grant of the patent:
**26.09.2001 Bulletin 2001/39**

(51) Int Cl.$^7$: **G11C 7/06**, G11C 16/06

(21) Application number: **96304435.9**

(22) Date of filing: **13.06.1996**

(54) **Sense amplifier circuit of a nonvolatile semiconductor memory device**

Leseverstärkerschaltung einer nichtflüchtigen Halbleiterspeicheranordnung

Circuit d'amplificateur de lecture d'un dispositif de mémoire non-volatile à semi-condcuteurs

(84) Designated Contracting States:
**DE GB IT**

(30) Priority: **13.06.1995 KR 9515577**
**30.06.1995 KR 9518965**
**30.06.1995 KR 9518968**

(43) Date of publication of application:
**12.02.1997 Bulletin 1997/07**

(73) Proprietor: **SAMSUNG ELECTRONICS CO., LTD.**
**Suwon-City, Kyungki-do (KR)**

(72) Inventors:
• **Kim, Myung-Jae**
**Suwon-city, Kyungki-do (KR)**
• **Jung, Tae-Sung**
**Goonpo-city, Kyungki-do (KR)**

(74) Representative: **Style, Kelda Camilla Karen et al**
**Page White & Farrer,**
**54 Doughty Street**
**London WC1N 2LS (GB)**

(56) References cited:
**EP-A- 0 474 238**     **EP-A- 0 618 589**
**US-A- 5 297 079**     **US-A- 5 300 839**

EP 0 758 127 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates to a sense amplifier circuit of nonvolatile semiconductor memory device, and particularly but not exclusively to a sense amplifier circuit in a flash electrically erasable and programmable read-only memory (hereinafter referred to as "EEPROM") with NAND structured cells.

Hard disk, which is mainly used as an auxiliary memory device in a battery operated computer system such as a portable microcomputer of a notebook size, occupies relatively too large an area of the system. For this reason, the designers of such a computer system are highly interested in the development of EEPROMs that are to be of a high density and an excellent performance, not taking up too much space. A small size of memory cells is a key point of this problem. Thus, an EEPROM with NAND structured cells is devised so as to make it possible to reduce the number of the selection transistors and the contact holes to a bit line per a cell. An improved structure of this NAND EEPROM and the art for erasing and programming the same EEPROM are introduced under the title of "A NAND STRUCTURED CELL WITH A NEW PROGRAMMING TECHNOLOGY FOR HIGHLY RELIABLE 5V-ONLY FLASH EEPROM" on pages 129-130 of the Symposium on VLSI Technology published in 1990. The NAND EEPROM reported in the paper has an operation mode to simultaneously erase the information programmed in the memory cells, which EPPROM is usually called a flash EEPROM or a flash memory.

EP-A-0618589 also discloses a NAND, EEPROM device and in particular discloses a semiconductor nonvolatile memory device which adopts a differential type sensing system comprising first and second bit lines connected in parallel with respect to a sense amplifier, comprising a first memory cell which is connected to a word line and a first bit line, a second memory cell which is connected to a word line common with said first memory cell and, connected to said second bit line, and a means for holding the potential of either bit line of said first and second bit lines at a first potential at the time of a predetermined operation, and, setting the potential of the other bit line at a second potential made to have a difference from said first potential for a predetermined time.

In a commonly used flash memory, zero voltage is applied to a gate terminal, i.e. a word line, of selected cell transistor during the read operation therein. The bit line connected the selected cell transistor is maintained at an initial precharge level in case that the selected cell transistor is programmed to have a positive threshold voltage. On the contrary, if the cell transistor is programmed to have a negative threshold voltage, the bit line is discharged to ground level. The sense amplifier used in this flash memory can sense and amplify a very small difference between the level on the bit line and the reference bit line, the bit line being maintained to a precharge level or changed to a ground voltage level during the read operation thereof.

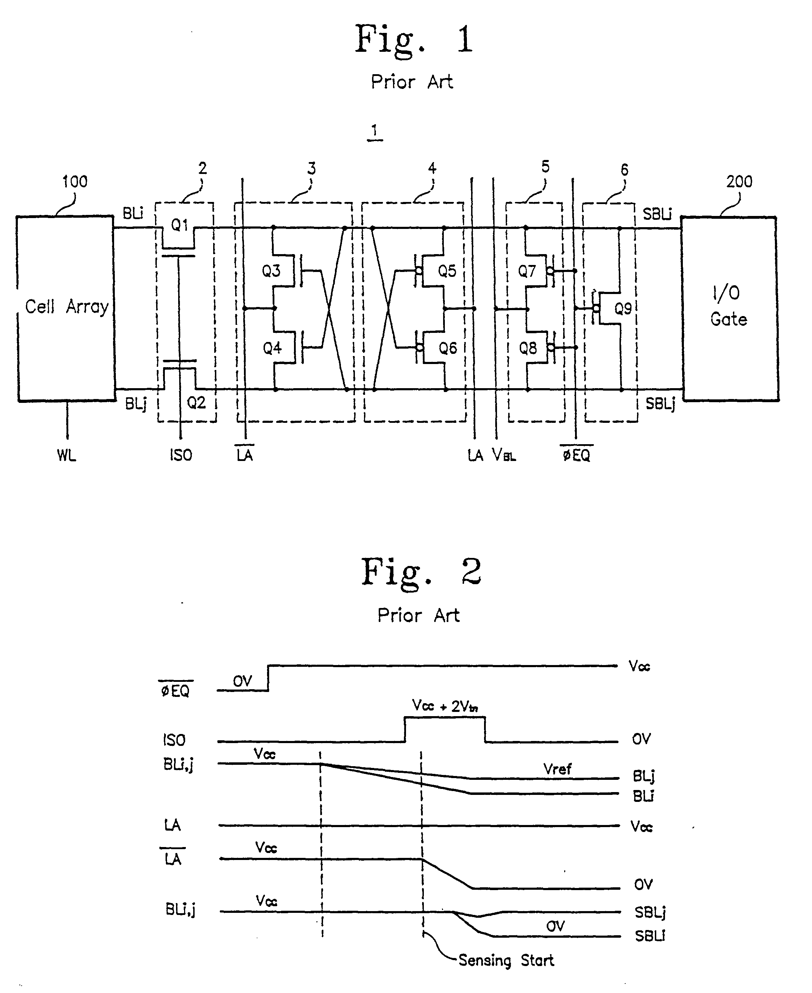

Fig. 1 illustrates an example of a prior art sense amplifier circuit used in a NAND flash EEPROM with folded bit line architecture, wherein a sense amplifier circuit 1 is located between a cell array 100 and an input/output gate circuit 200. The cell array 100 includes a reference cell array for providing a reference voltage and the input/output gate circuit 200 is provided to transmit the data amplified by the sense amplifier circuit 1 to the input/output lines. In the sense amplifier circuit 1, a bit line isolation section 2 is located between the bit lines BLi and BLj connected to the cell array 100 and the sub-bit lines SBLi and SBLj connected to the input/output gate circuit 200. The bit line isolation section 2 has the n-channel metal oxide semiconductor field effect transistors Q1 and Q2 for selectively isolating the bit lines BLi and BLj from the sub-bit lines SBLi and SBLj. The sub-bit lines BLi and SBLj are connected to an n-latch sense amplifier section 3 having n-channel MOS transistors Q3 and Q4, a p-latch sense amplifier section 4 having p-channel MOS transistors Q5 and Q6, a precharging section 5 having p-channel MOS transistors Q7 and Q8, and an equalizing section 6 having a p-channel MOS transistor Q9, as shown in Fig. 1. To describe how this sense amplifier circuit operates, it is assumed that, for convenient description, a voltage developed in an erased cell which is selected is applied to a bit line BLi and a read reference voltage obtained from a reference cell which is selected is applied to a bit line BLj.

Fig. 2 is a timing chart illustrating a sensing operation of the sense amplifier circuit. In Fig. 2, the bit lines BLi and BLj and the latch amplifier driving lines LA and /LA are precharged to a source voltage $V_{cc}$, and the sub-bit lines SBLi and SBLj are also precharged to $V_{cc}$ by a precharge control signal /ΦEQ. When the voltages of the bit lines BLi and BLj sufficiently develop according to a cell selection, an isolation control signal ISO of pulse waveform is generated. With this signal ISO, the isolation transistors Q1 and Q2 are turned on and the voltage of the n-latch sense amplifier driving line /LA decreases to the level of ground voltage (GND), or 0V. To prevent the voltage drop of the bit lines by the isolation transistors Q1 and Q2, the isolation control signal ISO of high level has to be maintained over $V_{cc} + 2V_{tn}$, where $V_{tn}$ indicates the threshold voltage of the n-channel MOS transistor. When the isolation transistors Q1 and Q2 are turned on, the voltages of sub-bit lines are changed owing to the charge sharing between the bit lines BLi and BLj and the sub-bit lines SBLi and SBLj. As the voltage of the sub-bit line SBLi which is in charge sharing with the bit line BLi electrically connected to the erased cells are decreased relatively quickly, the transistors Q3 and Q6 are turned on. As a result, the voltage of the sub-bit line SBLi falls down to ground level by the latch amplifier driving lines LA and /LA, and that of the sub-bit line SBLj pulls up to $V_{cc}$ level. The very small difference between potential level on the bit lines BLi and BLj is sensed and amplified by the sense amplifier circuit 1 and transmitted to the input/output gate circuit 200.

Hence, when the above-described sense amplifier circuit 1 performs a sensing operation, there may be some limits that the isolation control signal ISO is a pulse waveform and its high level is to be controlled over $V_{cc} + 2V_{tn}$. Additionally, the sense amplifier circuit 1 is affected by the bit line load in the cell array, which causes the lowering of sensing speed and the increase in peak current. The wording "bit line load" means the load impedance along the data path (i.e., bit lines) at the side of the cell array. Only the normal sensing operation is performed in the sense amplifier circuit 1, but the inverted sensing operation where the data memorized in a selected cell is inversely outputted can not be performed in the circuit, which limits the design of the input/output circuit.

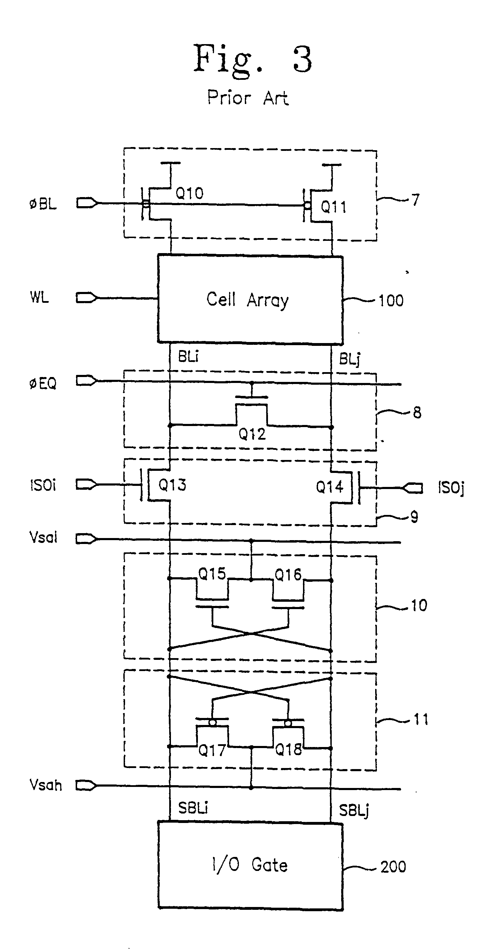

Fig. 3 shows another conventional sense amplifier circuit used in a NAND flash EEPROM with folded bit line architecture. In Fig. 3, the EEPROM has a cell array 100 which is located between a precharging section 7 having p-channel MOS transistors Q10 and Q11 and an equalizing section 8 having an n-channel MOS transistor Q12. Between bit lines BLi and BLj and sub-bit lines SBLi and SBLj, a bit line isolation section 9 having n-channel MOS transistors Q13 and Q14 is connected. Electrical connection of the bit lines to the sub-bit lines is selectively performed by the bit line isolation section 9. The sub-bit lines SBLi and SBLj are commonly connected to an n-latch sense amplifier section 10 having two n-channel MOS transistors Q15 and Q16 and a p-latch sense amplifier section 11 having two p-channel MOS transistors Q17 and Q18. Drain terminals of the transistors Q15 and Q16 are commonly connected to a latch amplifier driving line $V_{sal}$ and the sources of the transistors Q17 and Q18 are commonly connected to a latch amplifier driving line $V_{sah}$.

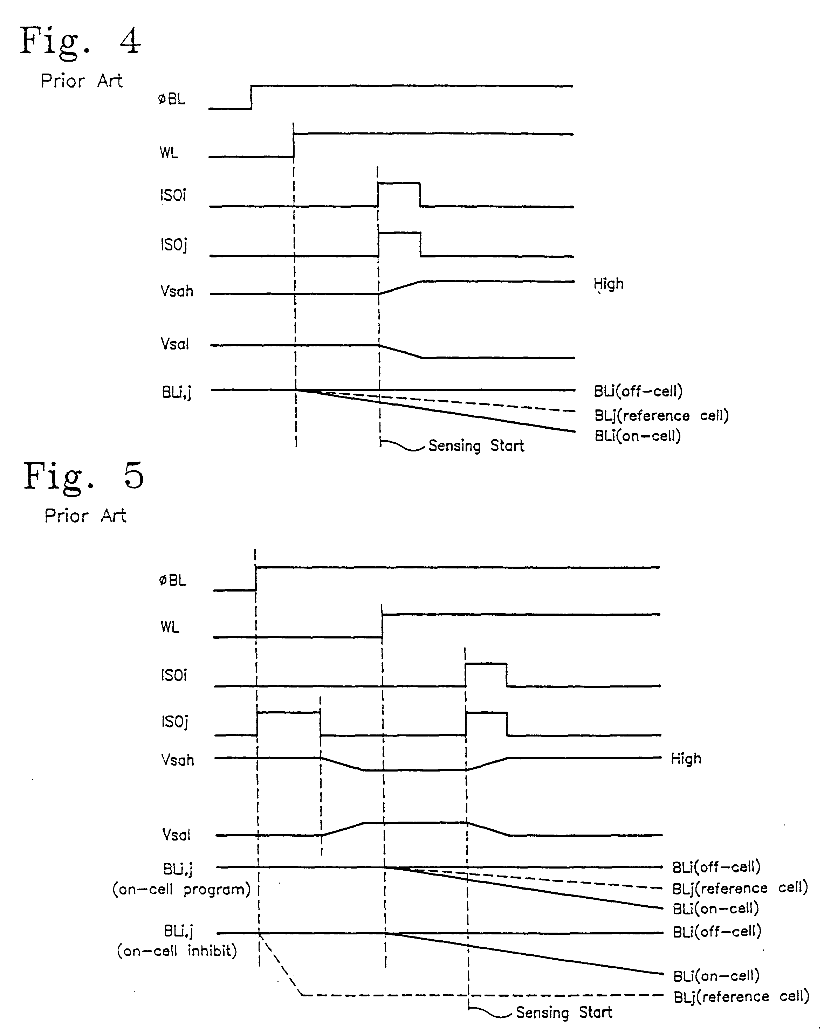

Fig. 4 is a timing chart showing the sensing operation in the read mode of the sense amplifier shown in Fig. 3.

With reference to Fig. 4, a voltage of the bit line BLi develops in accordance with the state of a cell which is selected by a word line signal WL. Then, if the selected cell is an off-cell, or a programmed cell, the cell transistor selected thus has positive threshold voltage. Accordingly, the selected cell transistor is turned off when a word line selection signal of zero volts is applied to the gate thereof, and the voltage of the bit line BLi is maintained to the precharge level. However, if the selected cell is an on-cell, or an erased cell, the selected cell transistor has negative threshold voltage to be turned on even though a word line selection signal of zero volts is applied to the gate thereof. As a result, the voltage of the bit line BLi is lower than that of the bit line BLj connected to a reference cell. And then, isolation control signals ISOi and ISOj of predetermined pulse duration are generated and therefore the isolation transistors Q13 and Q14 are turned on. While the isolation control signals ISOi and ISOj of pulse waveform are activated, the voltage of n-latch sense amplifier driving line $V_{sal}$ is lowered from a precharge level of high level to a low level and that of p-latch sense amplifier driving line $V_{sah}$ is increased from a precharge level of low level to a high level. Thus, the data of the bit line BLi are detected by the sense amplifier sections 10 and 11. It may be known, therefore, that the minute difference between level on the bit lines BLi and BLj is amplified by the sense amplifier circuit 1 and transmitted to the input/output gate circuit 200.

Fig. 5 is a timing chart illustrating the sensing operation of the sense amplifier circuit in program verification and inhibition modes of the NAND flash memory shown in Fig. 3. Herein, the program verification means that, when a negative threshold voltage of a selected on-cell shifts to a positive threshold voltage, a programming operation continues to be performed until the threshold voltage detected from the on-cell becomes a preset threshold voltage. The program inhibition means that unselected cells are not programmed during the programming operation.

In order that the on-cell connected to the selected bit line BLi is not programmed during the programming operation, the voltage of the sub-bit line SBLi corresponding to the selected bit line BLi has to be maintained to $V_{cc}$. As shown in Fig. 5, the isolation control signal ISOj is activated under the condition that the sub-bit lines SBLi and SBLj are precharged respectively to $V_{cc}$ and GND level (zero Volt) by an externally applied data signal from the I/O gate circuit 200 during the program inhibition, and then the unselected bit line BLj connected to the reference cell is discharged to have GND level. At this time, the latch driving signals $V_{sal}$ and $V_{sah}$ are inactivated. Thus, in the following read operation, because the voltage of the sub-line SBLj is previously set to GND level even though a voltage of the bit line BLi connected to the on-cell is lowered to low level, the voltage of the sub-line SBLi is maintained to $V_{cc}$ level.

Also, in the programming operation of on-cell, or erased cell, connected to the selected bit line BLi, the sub-bit lines SBLi and SBLj are precharged respectively to GND and $V_{cc}$ level by the externally applied data signal, and the same operation as in the program verification is carried out. As the voltage of the sub-bit line SBLi shifts from GND level to $V_{cc}$ level in the following read operation of cells, the program inhibition is effective and then the programming operation is automatically terminated.

During a sensing operation of bit line, there are changes in the sensing margin and the decoupling margin between the bit lines and the sub-bit lines according to the process parameters and the overlapping degree of the isolation control signals ISOi and ISOj and the latch driving signals $V_{sal}$ and $V_{sah}$.

Moreover, since the isolation transistor Q14 connected to the bit line BLj has to be previously turned on during the program verification and inhibition, there are problems that an additional control logic is required for the sense amplifier circuit and the time required for the program verification is prolonged.

Therefore, it is an aim of embodiments of the invention to provide a sense amplifier circuit of a nonvolatile semiconductor memory device with folded bit line architecture, in which a stable sensing operation may be performed without using any bit line isolation signal of pulse waveform.

It is another aim of embodiments of the invention to provide a sense amplifier circuit which is not affected by the load impedance of the bit line connected to memory cells in a nonvolatile semiconductor memory device with folded bit line architecture.

It is a further aim of embodiments of the invention to provide a sense amplifier circuit of low power consumption.

It is another aim of embodiments of the invention to provide a sense amplifier circuit for a flash memory device which is capable not only of a normal sensing operation but also of inverted sensing operation.

It is still further an aim of embodiments of the invention to provide a sense amplifier circuit for a flash memory device which is suitable to minimize the changes in decoupling and sensing margins during a sensing operation of bit lines.

It is another aim of embodiments of the invention to provide a sense amplifier circuit for a flash memory device which is capable of carrying out a high speed sensing operation.

It is still another aim of embodiments of the invention to provide a sense amplifier circuit for a flash memory device which is suitable for program verification and inhibition.

According to one aspect of the present invention there is provided a nonvoltatile semiconductor memory device having a sense amplifier circuit and a NAND structured memory cell array for storing information and a reference cell array for providing a reference voltage, said circuit comprising a pair of bit lines comprising a first and second bit line connected to said NAND structured memory cell array and said reference cell array, respectively, a pair of sub-bit lines comprising a first and second sub-line corresponding to said bit lines, respectively, bit line isolating means for electrically and selectively isolating said bit lines from said sub-bit lines in response to an externally applied isolation control signal during a precharging period and a sensing period, means for precharging and equalizing said sub-bit lines during a precharging period, a signal line for receiving an externally applied voltage signal, a voltage-controlled current source having first and second current paths connected to said first and second sub-bit lines respectively, whereby a current amount flowing through said second current path is adjusted in accordance with a voltage level of said first bit line and a current amount flowing through said first current path is adjusted in accordance with a voltage level of the said second bit line, switching means for electrically and selectively connecting at least one of said first and second current paths to said signal line in response to a switching control signal, and amplifier means for amplifying voltage levels of said sub-bit lines to first and second predetermined voltage levels, respectively when a potential difference between, said sub-bit lines is more than a predetermined voltage.

For a better understanding of the present invention and as to how the same may be carried into effect, reference will now be made by way of example to the accompanying drawings in which:

Fig. 1 is a circuit diagram showing a prior art sense amplifier for a nonvolatile semiconductor memory device;

Fig. 2 is a timing chart showing the sensing operation of the sense amplifier shown in Fig. 1;

Fig. 3 is a circuit diagram showing another prior art sense amplifier for a nonvolatile semiconductor memory device;

Fig. 4 is a timing chart showing the sensing operation in a read mode of the sense amplifier shown in Fig. 3;

Fig. 5 is a timing chart showing the sensing operation in program verification and inhibition modes of the sense amplifier shown in Fig. 3;

Fig. 6 is a circuit diagram showing the construction of a sense amplifier for a nonvolatile semiconductor memory device in accordance with an embodiment of the present invention;

Fig. 7 is a timing chart showing a normal sensing operation of the sense amplifier shown in Fig. 6;

Fig. 8 is a timing chart showing an inverted sensing operation of the sense amplifier shown in Fig. 6;

Fig. 9 is a diagram showing waveforms of the bit line voltage as a result of simulation of the normal sensing operation of the sense amplifier shown in Fig. 6;

Fig. 10 is a diagram showing waveforms of the bit line voltage as a result of simulation of the inverted sensing operation of the sense amplifier shown in Fig. 6;

Fig. 11 is a circuit diagram showing the construction of a sense amplifier for a nonvolatile semiconductor memory device in accordance with another embodiment of the present invention;

Fig. 12 is a timing chart showing the sensing operation in a read mode of the sense amplifier shown in Fig. 11;

Fig. 13 is a timing chart showing the sensing operation in program verification and inhibition modes of the sense amplifier shown in Fig. 11;

Fig. 14 is a circuit diagram showing the construction of a sense amplifier for a nonvolatile semiconductor memory device in accordance with a further embodiment of the present invention;

Fig. 15 is a timing chart showing the sensing operation in a read mode of the sense amplifier shown in Fig. 14; and
Fig. 16 is a timing chart showing the sensing operation in program verification and inhibition modes of the sense amplifier of Fig. 14.

For convenient description, assuming that a voltage developed in an erased cell which is selected is applied to a bit line BLi and a read reference voltage obtained from a reference cell which is selected is applied to a bit line BLj.

Example 1

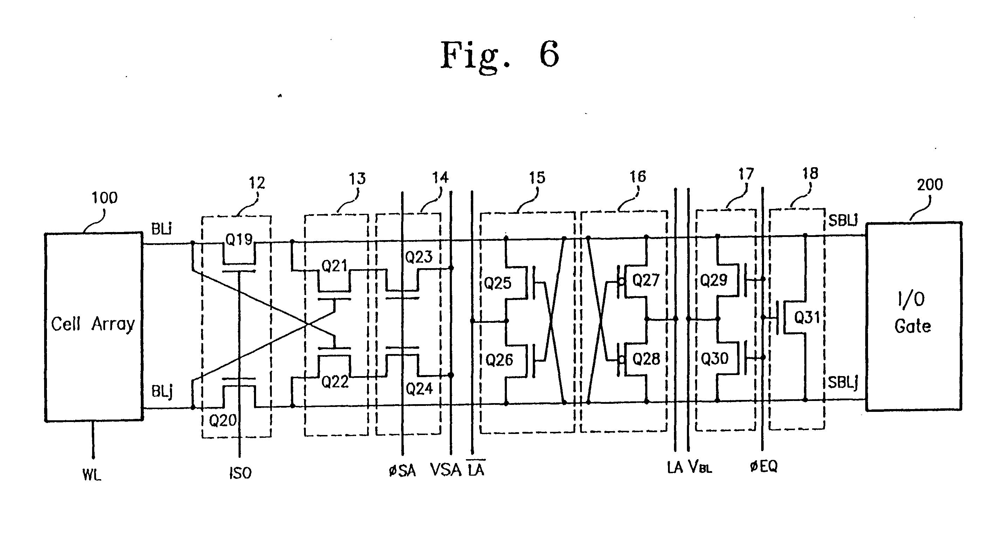

Fig. 6 shows a sense amplifier circuit for NAND flash memory device with folded bit line architecture according to a preferred embodiment of the present invention. In Fig. 6, the sense amplifier circuit is located between an input/output gate circuit 200 and a cell array 100 which includes a NAND structured memory cell array for storing input data and a reference cell array for providing a reference voltage to bit lines. The sense amplifier circuit has a bit line isolating section 12 which is constituted by two n-channel MOS transistors Q19 and Q20 and located between bit lines BLi and BLj and sub-bit lines SBLi and SBLj. The bit lines BLi and BLj are connected to the cell array 100 and the sub-bit lines SBLi and SBLj are connected to the input/output gate circuit 200. To gates of the transistors Q19 and Q20, an isolation control signal is applied. The respective bit lines BLi and BLj are electrically and selectively isolated from the sub-bit lines SBLi and SBLj by the bit line isolating section 12. The sub-bit lines SBLi and SBLj are connected to a voltage-controlled current source 13 of latch structure having n-channel MOS transistors Q21 and Q22, and a switching section 14 having n-channel MOS transistors Q23 and Q24 is connected between the voltage-controlled current source 13 and a signal line VSA. Drain and source of the transistor Q21 are connected respectively to the sub-bit line SBLi and drain of the transistor Q21, and gate of the transistor Q21 is commonly connected to the bit line BLj and drain of the isolation transistor Q20. Drain and source of the transistor Q22 are connected respectively to the sub-bit line SBLj and drain of the transistor Q24, and gate thereof is commonly connected to the bit line BLi and drain of the isolation transistor Q19. Sources of the transistors Q23 and Q24 of the switching portion 14 are commonly connected to the signal line VSA and gates thereof receive a switching control signal $\Phi$SA of pulse waveform.

Additionally, the sub-bit lines SBLi and SBLj are connected to an n-latch sense amplifier section 15 having n-channel MOS transistors Q25 and Q26, a p-latch sense amplifier section 16 having p-channel MOS transistors Q27 and Q28, a precharging section 17 having n-channel MOS transistors Q29 and Q30, and an equalizing section 18 comprising n-channel MOS transistor Q31.

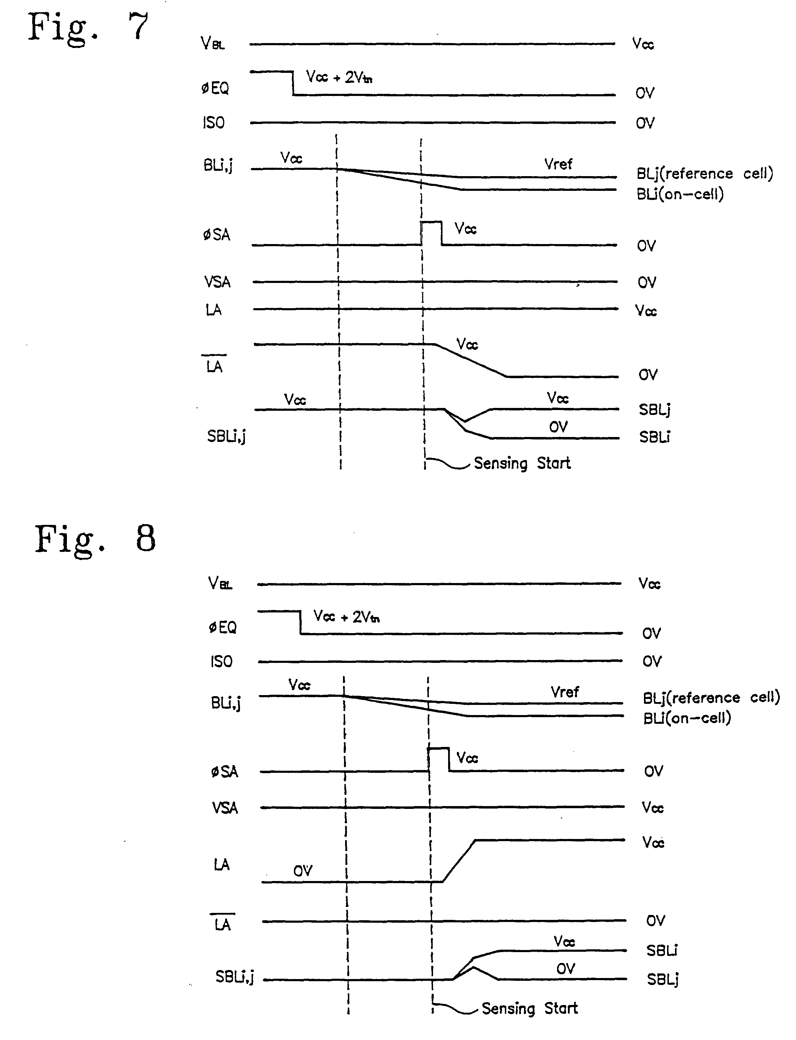

Referring to Fig. 7, the bit lines BLi and BLj are precharged to $V_{cc}$ level, and the sub-bit lines SBLi and SBLj are also precharged to $V_{cc}$ level by the precharging section 17 and equalizing section 18 while the precharging and equalizing control signal $\Phi$EQ is maintained to the level of $V_{cc}+2V_{tn}$, where $V_{tn}$ represents the threshold voltage of n-channel MOS transistor. During this sensing operation, the voltages of the signal line VSA and the p-latch sense amplifier driving line LA are precharged respectively to GND and $V_{cc}$ level, and the n-latch sense amplifier driving line /LA is maintained to the level of $V_{cc}$ before the switching control signal $\Phi$SA of a pulse are generated. In this condition, a memory cell is selected by a word line signal WL. According to the state of the selected memory cell, for example on-cell or off-cell, the respective voltages of the bit lines develop. Then, when there is a potential difference between the bit lines BLi and BLj, that is, if the voltage of the bit line BLi gets lower than that of the bit line BLj, the switching control signal $\Phi$SA is activated. As a result, a sensing operation for detecting the potential difference therebetween is started.

If the switching control signal $\Phi$SA is shifted to high level, all the transistors Q23 and Q24 are turned on and the sub-bit line SBLi is discharged faster than the sub-bit line SBLj by the transistor Q21, because the voltage of the bit line BLj is higher than that of the bit line BLi. As a result, the voltage of SBLi is lower than that of SBLj. The voltage of the n-latch sense amplifier driving line /LA shifts from $V_{cc}$ to GND level and that of the p-latch sense amplifier driving line LA is maintained to the level of $V_{cc}$, so that the transistors Q25 and Q28 are turned on and the voltages of the sub-bit lines SBLi and SBLj is shifted respectively to GND and $V_{cc}$. In such manner, the minute potential difference between the bit lines BLi and BLj is amplified by the sense amplifier circuit.

As shown again in Fig. 7, the sensing operation is performed under the condition that the signal line VSA is precharged to GND level and the sub-bit lines SBLi and SBLj are precharged to the level of $V_{cc}$. It is understood, for example, in Fig. 7 that the sub-bit lines SBLi and SBLj are developed respectively to GND and $V_{cc}$ in case of the on-cell data sensing operation in which the bit lines BLi and BLj are developed respectively to GND level and the reference voltage $V_{ref}$. As known in the above description, the data having the same as the phase of the cell data is accessed by the sense amplifier circuit embodying the present invention.

In the first embodiment, the switching control signal $\Phi$SA has a pulse waveform as shown in Fig. 7 so as not to continuously form a DC current path from the sub-bit lines SBLi and SBLj through the voltage-controlled current source 13 and the switching section 14 to the GND (that is the signal line VSA) by developed bit lines BLi and BLj after substantial sensing operation. Also, because the isolation control signal ISO is inactivated and maintained to GND level during the sensing operation, the bit lines BLi and BLj are electrically and completely isolated from the sense amplifier circuit, so that the sensing operation is not affected at all by the bit line load. As a result, the sensing speed is further improved and the peak current is reduced.

In Fig. 8, a timing chart for the inverted sensing operation of the sense amplifier circuit is illustrated. As shown in Fig. 8, the bit lines BLi and BLj are precharged to level of $V_{cc}$. While the precharging and equalizing control signal $\Phi$EQ is maintained to $V_{cc} + 2V_{tn}$, the sub-bit lines SBLi and SBLj are precharged to GND level by the precharging section 17 and equalizing section 18. During such inverted read operation, the signal line VSA and the p-latch sense amplifier driving line LA are maintained respectively to $V_{cc}$ and GND level, and the both latch amplifier driving lines LA and /LA continue to be maintained to level of GND before the switching control signal $\Phi$SA is generated as a pulse, so that a memory cell is selected by the word line signal WL. As a potential difference between the bit lines BLi and BLj is generated, the switching control signal $\Phi$SA is activated.

If the switching control signal $\Phi$SA is shifted from low level to high level, the transistors Q23 and Q24 are turned on and the sensing operation is started. Because the voltage of the bit line BLj then is higher than that of the bit line BLi, the sub-bit line SBLi is charged faster than SBLj. As a result, the voltage of SBLi is higher than that of SBLj.

At this time, the voltage of the p-latch sense amplifier driving line LA also is shifted from GND level to $V_{cc}$ and that of the n-latch sense amplifier driving line /LA continues to be maintained to level of GND, so that the transistors Q26 and Q27 of the voltage-controlled current sources 15 and 16 are turned on. Thus, the voltages of the sub-bit lines SBLi and SBLj are developed respectively to $V_{cc}$ and GND level and a very small difference between potential level on the bit lines BLi and BLj is sensed and amplified by the sense amplifier circuit.

As above mentioned, the sensing operation is performed under the condition that the signal line VSA is precharged to level of $V_{cc}$ and the sub-bit lines SBLi and SBLj are precharged to GND, as shown in Fig. 8. As the sub-bit lines SBLi and SBLj are developed respectively to GND and $V_{cc}$ level in case of the sensing of on-cell data in which the bit lines BLi and BLj is developed respectively to GND level and the reference voltage $V_{ref}$. As can be seen in the above description, the data which is in the opposite phase to the cell data may be accessed by the sense amplifier circuit according to the first embodiment of the present invention.

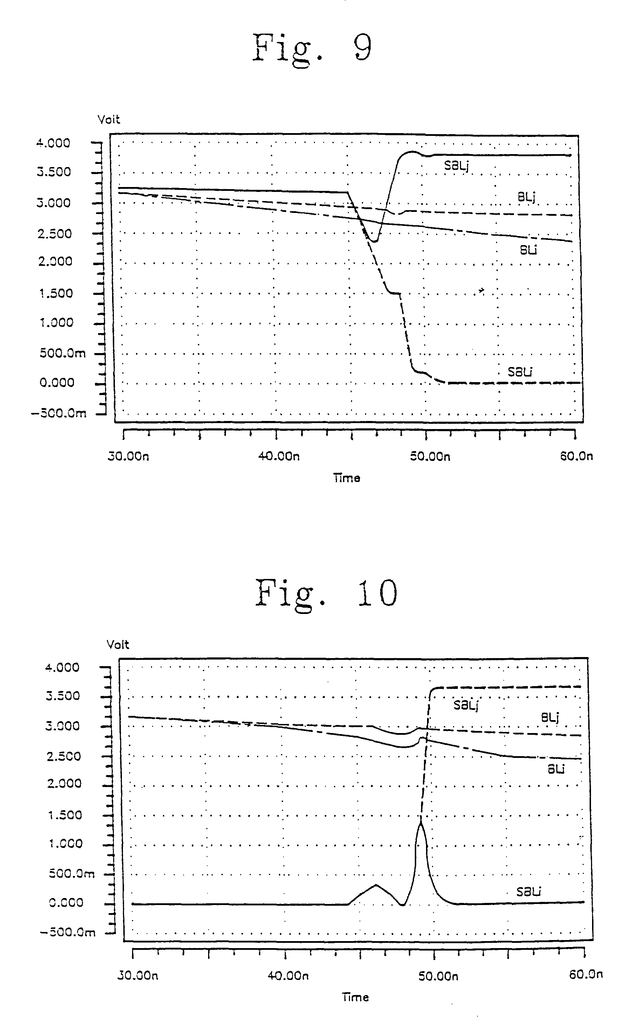

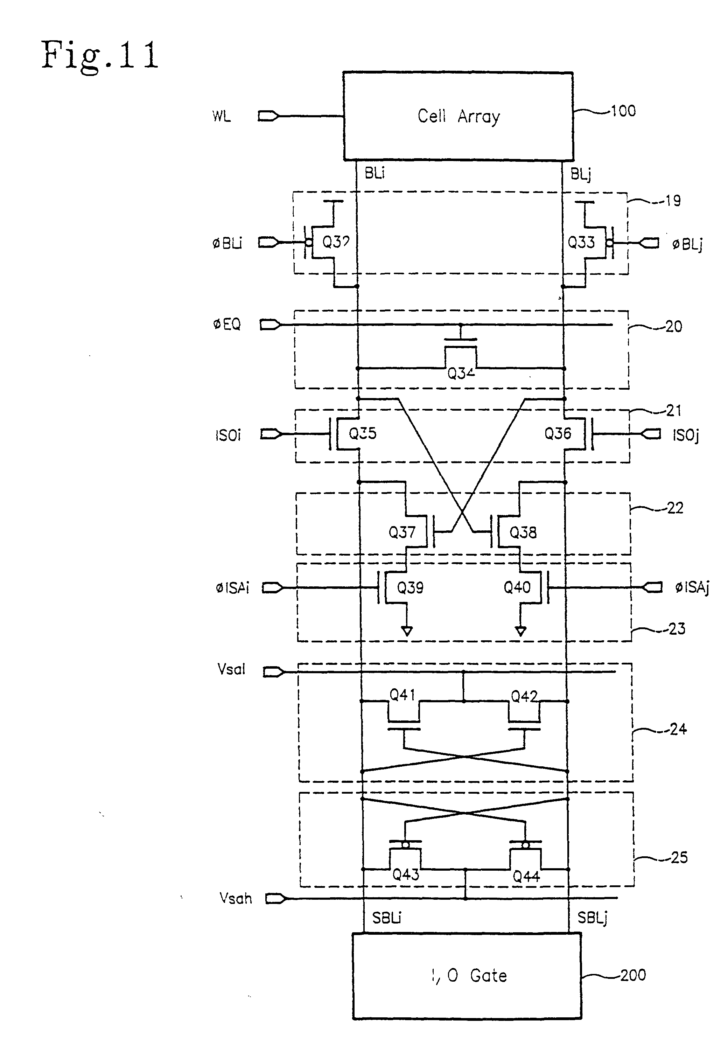

With reference to Figs. 9 and 10, voltage waveforms of the bit lines are shown as a result of the simulation of the normal and the inverted sensing operation in the sense amplifier circuit of the invention. The simulation is performed under the condition that the power voltage $V_{cc}$ is 3.8V and the temperature is about -5 °C.

The sense amplifier circuit and the cell array stage connected through the bit lines BLi and BLj are electrically isolated during the above sensing operation, so that the sensing speed can be further faster improved and a peak current hardly flows through the sense amplifier circuit.

As described above, the sense amplifier circuit according to the embodiment of the present invention may carry out a stable sensing operation at a further higher speed without using a bit line isolation signal of pulse waveform to the bit line isolation section.

Also a peak current flowing through the sense amplifier circuit is larger reduced. Because both the normal and the inverted sensing operations can be performed, designing a nonvolatile memory device is not limited.

Example 2

Fig. 11 shows a sense amplifier circuit for NAND flash memory device with folded bit line architecture according to a second embodiment of the present invention.

Referring to Fig. 11, the sense amplifier circuit is located between an input/output gate circuit 200 and a cell array 100 having a memory cell array and a reference cell array. The circuit has a bit line isolation section 21 which is constituted by n-channel MOS transistors Q35 and Q36 and located between bit lines BLi and BLj and sub-bit lines SBLi and SBLj. The bit lines BLi and BLj are connected to the cell array 100 and the sub-bit lines SBLi and SBLj are connected to the input/output gate circuit 200.

In the circuit of Fig. 11, to the bit lines BLi and BLj, a precharging section 19 having p-channel MOS transistors Q32 and Q33, and an equalizing section 20 having an n-channel MOS transistor Q34 are connected. To the sub-bit lines SBLi and SBLj, a voltage-controlled current source 22 having n-channel MOS transistors Q37 and Q38 is connected. Between the voltage-controlled current source 22 and a ground (or, a potential lower than $V_{cc}$), a switching section 23 is connected. The switching section 23 is constituted by two n-channel MOS transistors Q39 and Q40.

In the voltage-controlled current source 22, drain and source of the transistor Q37 are connected respectively to the sub-bit line SBLi and drain of the transistor Q39, and the gate thereof is commonly to the bit line BLj and drain of the isolation transistor Q36. Drain and source of the transistor Q38 are connected respectively to the sub-bit line SBLj and drain of the transistor Q40, and the gate thereof is commonly to the bit line BLi and the drain of the isolation transistor Q35. Sources of the transistors Q39 and Q40 are commonly connected to a ground or a terminal for receiving a voltage lower than $V_{cc}$ level, and the gates thereof receive switching control signals $\Phi$SAi and $\Phi$SAj of pulse waveform. To the sub-bit lines SBLi and SBLj, an n-latch sense amplifier section 24 having n-channel MOS transistors Q41 and Q42, and a p-latch sense amplifier section 25 having p-channel MOS transistors Q43 and Q44 are commonly connected.

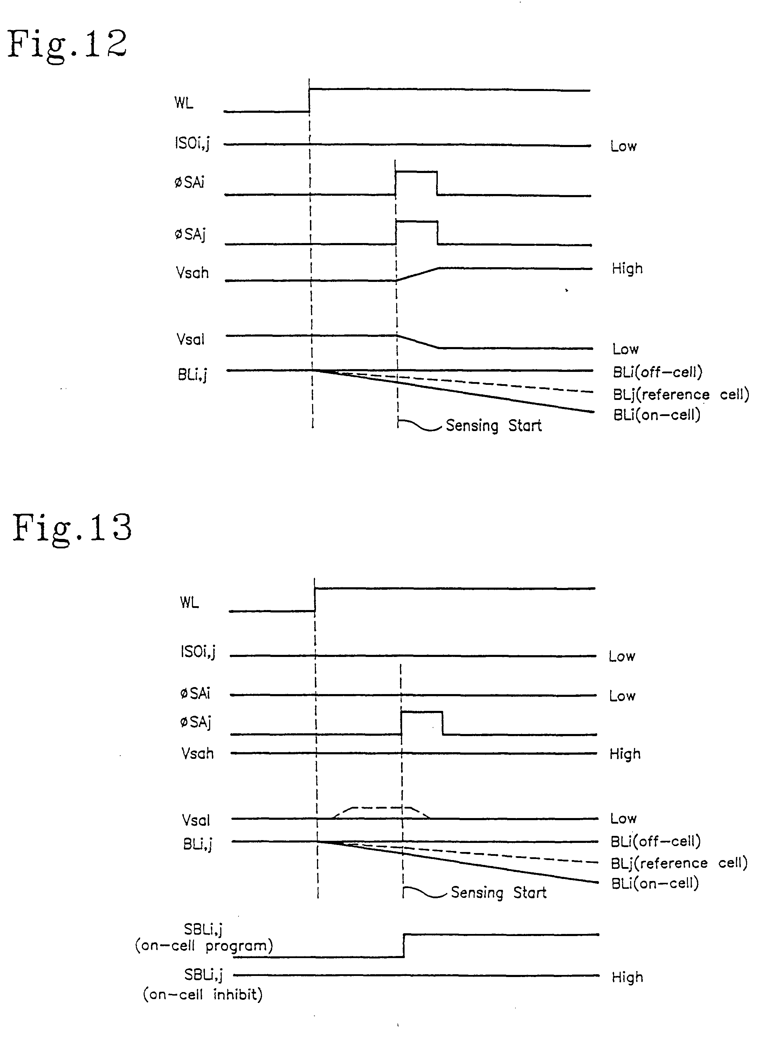

The sensing operation of the sense amplifier circuit of Fig. 11 will be described hereinafter with reference to a timing chart of Fig. 12.

As shown in Fig. 12, the bit lines BLi and BLj are precharged to level of $V_{cc}$ while a word line signal WL is at low level. Then, the isolation control signals ISOi and ISOj and the p-latch sense amplifier driving line $V_{sah}$ are maintained to ground level, and the n-latch sense amplifier driving line $V_{sal}$ is maintained to level of $V_{cc}$. In this state, a memory cell is selected by the shift of the word line signal WL to high level. In Fig. 12, each of bit line BLi and BLj is developed and a very small potential difference is generated between them. The switching control signals $\Phi$SAi and $\Phi$SAj are activated, and the p-latch sense amplifier driving line $V_{sah}$ and the n-latch sense amplifier driving line $V_{sal}$ are shifted from precharge levels respectively to high level of $V_{cc}$ and low level of a ground. At this time, the read operation for sensing a potential difference between the bit lines BLi and BLj is started.

On the other hand, when each of the switching control signals $\Phi$SAi and $\Phi$SAj is shifted to high level, all the transistors Q39 and Q40 are turned on.

If a memory cell which is selected by the word line signal WL is an on-cell, namely an erased cell, the current amount flowing through the transistor Q37 becomes more than that flowing through the transistor Q38 . This is because the bit line BLj has higher potential than the bit line BLi. Accordingly, the sub-bit line SBLi is discharged faster than SBLj, so that the potential of SBLi is lower than that of SBLj. The transistors Q41 and Q44 then are turned on by the latch driving lines $V_{sal}$ and $V_{sah}$, resulting in the development of voltages of the sub-bit lines SBLi and SBLj respectively to GND and $V_{cc}$. As a result, the minute potential difference between the bit lines BLi and BLj is sensed and amplified by the sense amplifier circuit.

On the contrary, if the selected memory cell is an off-cell, namely a programmed cell, the current amount flowing through the transistor Q38 becomes more than that flowing through the transistor Q37 . This is because the bit line BLi has higher potential than the bit line BLj. Accordingly, the sub-bit line SBLj is discharged faster than SBLi, so that the potential of SBLj is lower than that of SBLi. The sub-bit lines SBLj and SBLi change respectively to GND and $V_{cc}$. As a result, the minute potential difference between the bit lines BLi and BLj is sensed and amplified by the sense amplifier circuit.

Similarly to the first embodiment, the switching control signals $\Phi$SAi, $\Phi$SAj have pulse waveforms as shown in Fig. 12 so as not to continuously form a DC current path from the precharged sub-bit lines SBLi and SBLj through the voltage-controlled current source 22 and the switching section 23 to the GND (that is the signal line VSA) by developed bit lines BLi and BLj after substantial sensing operation. Also, because the isolation control signals ISOi and ISOj are inactivated and maintained to GND level during the sensing operation, the bit lines BLi and BLj are electrically and completely decoupled with the sense amplifier circuit, so that the stable sensing operation is performed with higher sensing speed and the reduction of current consumption.

Fig. 13 is a timing chart illustrating the sensing operation of the sense amplifier circuit of Fig. 11 for program verification and inhibition.

Referring to Fig. 13, in order that the on-cell connected to the selected bit line BLi is not programmed, the sub-bit line SBLi corresponding to the bit line BLi has to be maintained to $V_{cc}$ level. During the program inhibition, the sub-bit lines SBLi and SBLj are precharged respectively to $V_{cc}$ and GND when the latch sense amplifier sections 24 and 25 hold the external data signals from the I/O gate circuit 200. Then, the isolation control signals ISOi and ISOj are inactivated, and therefore the read operation, or the sensing operation is performed. At this time, with the activation of only the switching control signal $\Phi$SAj , only the transistor Q40 in the switching section 23 is turned on. The unselected sub-bit line SBLj the is precharged to GND level and the latch driving signals $V_{sal}$ and $V_{sah}$ are at active sate. On the contrary, the driving signal $V_{sal}$ of the n-latch sense amplifier section 24 is temporarily at inactive state and changes to be at active state when the switching control signal $\Phi$SAj is activated.

During the following read operation, because the sub-bit line SBLj is maintained to GND level, the potential of the sub-bit line SBLj continues to be maintained to Vcc level during the following sensing operation, even though that of the selected bit line BLi is developed to low level. Therefore, the sub-bit line SBLi continues to be maintained to $V_{cc}$ level for the program inhibition of the selected on-cell.

The programming operation of on-cells (that is, erased cells) will be described hereinafter. Assuming that the on-cells are connected to the selected bit line BLi and the selected bit line BLi is maintained to GND level during the programming operation.

The sub-bit lines SBLi and SBLj are precharged respectively to GND and $V_{cc}$ by the external data signals from the I/O gate circuit 200, and then the same operation as in the program verification wellknown in the art is carried out. If the selected cell is sufficiently programmed during the programming operation, that is, the bit line BLj is higher than a reference voltage, the conductivity of the transistor Q38 is higher than that of the transistor Q37. In other words, when the switching control signal $\Phi$SAj is at active state under the sufficiently programmed condition, a current flowing from the sub-bit line SBLj through the transistor Q38 of the latch amplifier 22 to the ground is rapidly increased in amount thereof. The sub-bit line SBLj then are sufficiently discharged to GND level. Thus, if the sub-bit line SBLi is shifted from GND level to $V_{cc}$ level by the latch sense amplifier sections 24 and 25, the sense amplifier circuit is in the program inhibition and the programming operation for the selected on-cell is automatically terminated.

As described above, so as to carry out the program verification and inhibition, because there is no need for previously making the isolation transistor Q36 connected to the reference bit line conductive, it is not necessary to prepare an additional control logic for turning on the isolation transistor Q36. Compared with the conventional sense amplifier, the memory device in which the sense amplifier circuit is embodied may have a further simplified construction and save time required for the program verification and inhabitation.

On the other hand, only the transistor Q31 of the bit line isolation section 21 is turned on so as to transmit the potential of the sub-bit line SBLi precharged by the external data signal to the bit line BLi, and only the precharged transistor Q33 is turned on for the program inhibition of the cell connected to the unselected bit line BLj, whereby the bit line BLj is precharged to $V_{cc}$ level.

As described above, the sense amplifier circuit according to the second embodiment may perform a stable sensing operation without providing bit line isolation signals of pulse waveforms to the bit line isolation section. Also the time required for the program verification and inhibition can be reduced.

Example 3

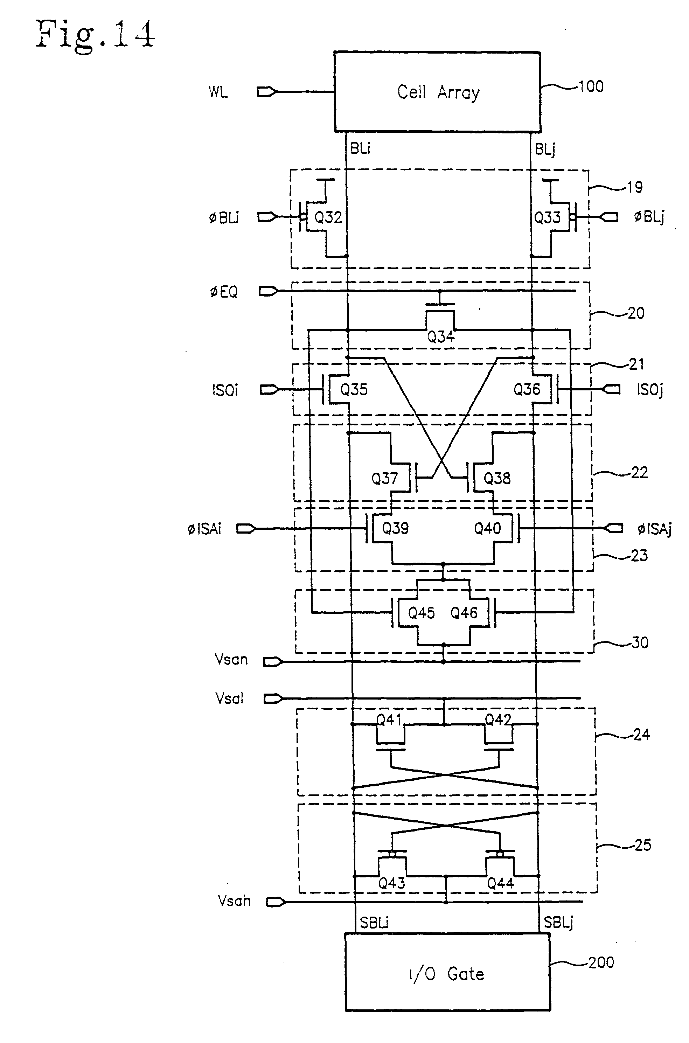

Fig. 14 shows a sense amplifier circuit for NAND flash memory device with folded bit line architecture according a third embodiment of the present invention. The sense amplifier circuit of Fig. 14 has the same construction as that of Fig. 11 except that an additional voltage-controlled current source 30 having n-channel MOS transistors Q45 and Q46 is located between the switching section 23 and a signal line $V_{san}$. Component elements having similar functions to the component elements of the sense amplifier circuit of the second embodiment (shown in Fig. 11) are indicated by the same reference numerals, and description thereof are omitted.

Referring to Fig. 14, drains of the transistors Q45 and Q46 are connected to each other, and sources thereof are also mutually connected. The sources of the transistors Q39 and Q40 are connected to the drains of the transistors Q45 and Q46, and the sources thereof are commonly connected to the signal line $V_{san}$. The gates of the transistors Q45 and Q46 are connected respectively to the bit lines BLi and BLj.

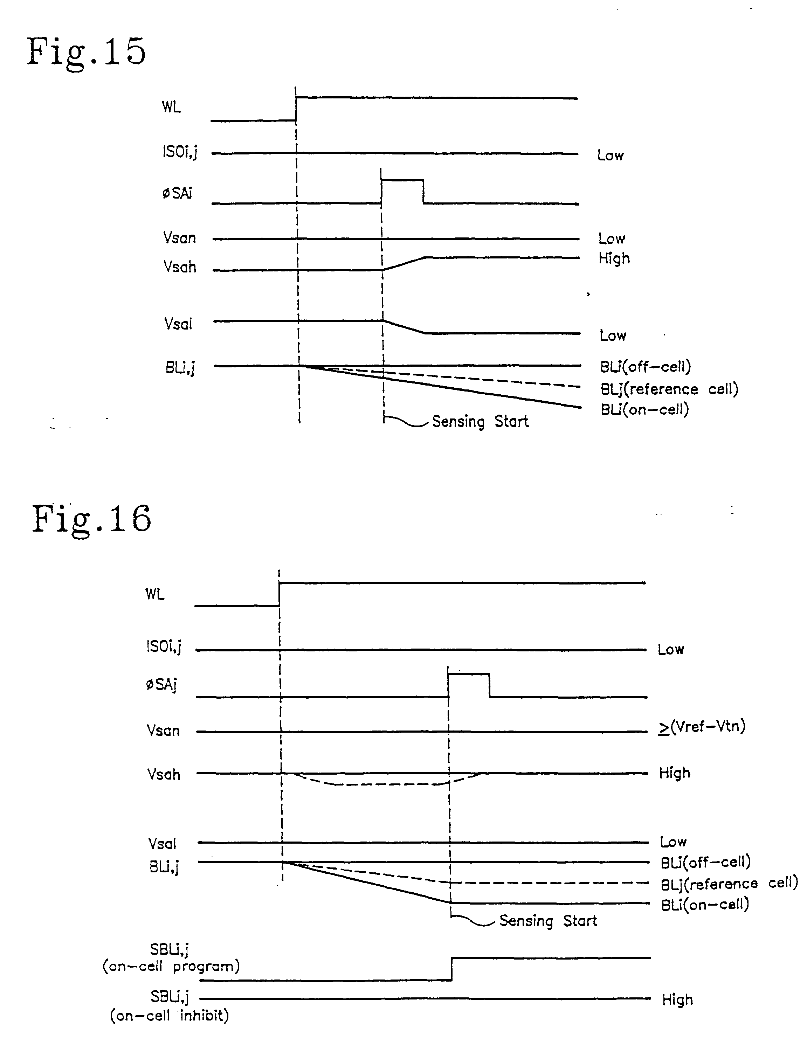

As shown in Fig. 15, a timing chart is illustrated to describe the sensing operation of the sense amplifier circuit during the read operation. The memory cell is selected according to the shift of the word line signal to high level after its precharging and equalizing operation, and a potential difference between the bit lines BLi and BLj is generated according to the state of the selected cells as shown in Fig. 15. And then, the switching control signals ΦSAi and ΦSAj are at active state, and the p-latch sense amplifier driving line $V_{sah}$ and the n-latch sense amplifier driving line $V_{sal}$ are shifted from precharge levels respectively to high level and low level. The read operation sensing a very small difference between level on the bit lines BLi and BLj is started. During the sensing operation, the sufficient gate bias is applied to the transistors Q45 and Q46 of the voltage-controlled current source 30 by the signal line $V_{san}$ which continues to be maintained to level of GND, and the transistors Q39 and Q40 are turned on when the switching control signals ΦSAi and ΦSAj are shifted to high level. The rest of the read operation in the sense amplifier circuit is the same as that in the secondary embodiment and its description is omitted.

Similarly to the second embodiment, the switching control signals ΦSAi, ΦSAj have pulse waveforms as shown in Fig. 12 so as not to continuously form a DC current path from the sub-bit lines SBLi and SBLj through the voltage-controlled current source 22 and the switching section 23 to the ground by developed bit lines BLi and BLj during the substantial sensing operation. Also, because the isolation control signals ISOi and ISOj are inactivated and maintained to GND level during the sensing operation, the bit lines BLi and BLj are electrically and completely decoupled with the sub-bit lines SBLi and SBLj, so that the stable sensing operation can be carried out at a higher sensing speed and the current consumption can be reduced.

Fig. 16 is a timing chart illustrating the sensing operation of the sense amplifier circuit of Fig. 14 for program verification and inhibition.

Referring to Fig. 16, in order that the on-cell connected to the selected bit line BLi is not programmed, a read operation is performed by the external data signal from the I/O gate circuit 200 under the condition that the sub-bit lines SBLi and SBLj are precharged respectively to $V_{cc}$ level and ground level. Then, to the signal line $V_{san}$, the voltage slightly higher than the rest of the reference voltage $V_{ref}$ subtracted by threshold voltages of the transistor Q45 or Q46 ($V_{tn}$) is applied, so that the transistors Q45 and Q46 respectively connected to the bit lines BLi and BLj through the gates thereof are both turned off. As a result, the sub-bit lines SBLi and SBLj continue to be maintained to precharge levels, that is, respectively $V_{cc}$ and GND level, and thereby the programming operation for the selected on-cell is inhibited.

On the contrary, the driving signal $V_{sah}$ of the p-latch sense amplifier section is temporarily inactivated and changes to be activated when the switching control signal ΦSAi is at active state as shown in Fig. 16. During the following programming operation for the on-cell (namely, erased cell) connected to the selected bit line BLi, the same operation as in the program verification mode is performed after the sub-bit lines SBLi and SBLj are precharged respectively to GND and $V_{cc}$ by the external data signal from the I/O gate circuit 200. If the selected cell is sufficiently programmed and the bit line BLi has the potential of more than $V_{san} + V_{tn}$, the transistor Q45 is turned on. If the selected cell is sufficiently programmed and the switching control signal ΦSAj is at active state, the sub-bit line SBLj is sufficiently discharged to be maintained to ground level. Then, the program inhibition for the selected on-cell is performed and the programming operation is automatically terminated when the sub-bit line SBLi is shifted from GND to $V_{cc}$ by the latch sense amplifier sections 24 and 25.

**Claims**

1. A nonvoltatile semiconductor memory device having a sense amplifier circuit and a NAND structured memory cell array for storing information and a reference cell array for providing a reference voltage, said circuit comprising:

   a pair of bit lines comprising a first ($BL_i$) and second ($BL_j$) bit line connected to said NAND structured memory cell array and said reference cell array, respectively;
   a pair of sub-bit lines comprising a first ($SBL_i$) and second ($SBL_j$) sub-bit line corresponding to said bit lines, respectively;
   bit line isolating means (12;21) for electrically and selectively isolating said bit lines ($BL_{ij}$) from said sub-bit lines ($SBL_{ij}$) in response to an externally applied isolation control signal (1S0) during a precharging period and a sensing period;
   means (17;18;19;20) for precharging and equalizing said sub-bit lines during a precharging period;
   a signal line (VSA;$V_{san}$) for receiving an externally applied voltage signal;
   a voltage-controlled current source having first and second current paths connected to said first and second sub-bit lines respectively, whereby a current amount flowing through said second current path is adjusted in accordance with a voltage level of said first bit line and a current amount flowing through said first current path is adjusted in accordance with a voltage level of the said second bit line;
   switching means for electrically and selectively connecting at least one of said first and second current paths to said signal line in response to a switching control signal; and
   amplifier means for amplifying voltage levels of said sub-bit lines to first and second predetermined voltage levels, respectively when a potential difference between said sub-bit lines is more than a predetermined voltage.

2. The nonvolatile semiconductor memory device as defined in claim 1, wherein said voltage-controlled current source (13;22) comprises a first n-channel MOS transistor (Q21;Q37) having a source-drain channel connected to one of said sub-bit lines ($SBL_i$) and a gate connected to the other of said bit lines ($BL_j$), and a second n-channel MOS transistor (Q22,Q38) having a source-drain channel connected to the other of said sub-bit lines ($SBL_j$) and a gate connected to the other one of said bit lines ($BL_i$).

3. The nonvolatile semiconductor memory device as defined in any of claims 1 to 2, wherein said switching means comprises a first MOS transistor (Q23; Q39) having a source-drain channel connected between said signal line and said source-drain channel of said first n-channel MOS transistor (Q21; Q37) and a gate for receiving said switching control signal (ΦSA;$ΦISA_i$), and a second MOS transistor (Q24;Q40) having a source-drain channel connected between said signal line and said source-drain channel of said second n-channel MOS transistor (Q22;Q38) and a gate for receiving said switching control signal (ΦSA;ΦISA).

4. The nonvolatile semiconductor memory device as defined in any preceding claim, wherein said switching control signal is a pulse signal having a pulse duration occurring after the starting of a sensing operation.

5. The nonvolatile semiconductor memory device as defined in claim 3 or claim 4 when appended to claim 3, wherein said amplifier means comprises a third n-channel MOS transistor (Q25;Q41) having a source-drain channel connected between a first driving line ($\overline{LA}$; $V_{sal}$) for receiving a first driving voltage signal and the first sub-bit line ($SBL_i$) and a gate connected to the second said sub-bit line ($SBL_j$), a fourth n-channel MOS transistor (Q26; Q42) having a source-drain channel connected between the first driving line ($\overline{LA}$; $V_{sal}$) and said second sub-bit lines ($SBL_j$) and a gate connected to the first said sub-bit line ($SBL_i$), a first p-channel MOS transistor (Q27; Q43) having a source-drain channel connected between a second driving line (LA; $V_{sah}$) for receiving a second driving voltage signal and the first said sub-bit line ($SBL_i$) and a gate connected to the second said sub-bit line ($SBL_j$) and a second p-channel MOS transistor (Q28;Q44) having a source-drain channel connected between said second driving line (LA;$V_{sah}$) and the second said sub-bit line ($SBL_j$) and a gate connected to the first said sub-bit line ($SBL_i$).

6. The nonvolatile semiconductor memory device as defined in any preceding claim, wherein said precharging and equalizing means comprises means for precharging each of said sub-bit lines to a source voltage level.

7. The nonvolatile semiconductor memory device as defined in any preceding claim, wherein said externally applied voltage signal is maintained to a ground voltage level during said precharging and sensing period.

8. The nonvolatile semiconductor memory device as defined in claim 5 or claim 6 or 7 when appended to claim 5, wherein said first driving voltage signal is maintained to a source voltage level during said precharging period and to a ground voltage level during said sensing period, and wherein said second driving voltage signal is maintained to said source voltage level during said precharging and sensing period.

9. The nonvolatile semiconductor memory device as defined in any of claims 1 to 5, wherein said precharging and equalizing means comprises means for precharging each of said sub-bit lines to said ground voltage level.

10. The nonvolatile semiconductor memory device as defined in claim 5 or claim 9 when appended to claim 5, wherein said externally applied voltage signal is maintained to said source voltage level during said precharging and sensing period.

11. The nonvolatile semiconductor memory device as defined in claim 5, or claim 9 or 10 when appended to claim 5, wherein said first driving voltage signal is maintained to said ground voltage level during said precharging and sensing period, said second driving voltage signal is maintained to said ground voltage level during said precharging period and to said source voltage level during said sensing period.

12. The nonvolatile semiconductor memory device as defined in claim 1 further comprising:

means for precharging and equalizing said bit lines during a precharging period; and
a constant voltage source for supplying the signal line with a constant voltage signal; whereby the pair of sub-bit lines ($SBL_{ij}$) are precharged by externally applied data signals; and
the switching means connects said first and second current paths to said constant voltage source in response to first ($\Phi ISA_i$) and second ($\Phi ISA_j$) switching control signals, respectively.

13. The nonvolatile semiconductor memory device is defined in claim 12, wherein the constant voltage signal is maintained to a ground voltage level during the precharging and sensing period.

14. The nonvolatile semiconductor memory device as defined in claim 12 or claim 13, wherein the first driving voltage signal is maintained to a source voltage level during the precharging period and to a ground voltage level during the sensing period, and wherein the second driving voltage signal is maintained to the ground voltage level during the precharging period and to the source voltage level during the sensing period.

15. The nonvolatile semiconductor memory device as defined in any of claims 12 to 14, further comprising another voltage-controlled current source having third and fourth current paths connected in series between said switching means and said constant voltage source and in parallel with each other, for adjusting a current amount flowing through said third current path in accordance with a voltage level of the one of said bit lines during the sensing period and adjusting a current amount flowing through said fourth current path in accordance with a voltage level of the other of said bit lines.

16. The nonvolatile semiconductor memory device as defined in any one of claims 12 to 15, wherein each of the first and second switching control signals is a pulse signal having a pulse duration occurring after the starting of a sensing operation for data read.

17. The nonvolatile semiconductor memory device as defined in any one of claims 12 to 16, wherein the first driving voltage signal is maintained to the ground voltage level during the precharging and sensing period for program verification and inhibition, and the second driving voltage signal is maintained to the source voltage level during the precharging period.

18. The nonvolatile semiconductor memory device as defined in claim 15, wherein the first switching control signal is maintained to the ground voltage level during the precharging and sensing period for program verification and inhibition, and the second driving voltage signal is a pulse signal having a pulse duration occurring after the starting of a sensing operation for program verification and inhibition.

19. The nonvolatile semiconductor memory device as defined in claim 12 or any claim appended thereto, wherein said bit line insulating means comprises means for electrically connecting the one of said bit lines to the one of said sub-bit lines in response to the activation of the second switching control signal during a programming operation of an on-cell connected to the one of said bit lines.

**Patentansprüche**

1.  Nichtflüchtige Halbleiterspeichervorrichtung, die einen Leseverstärker und eine Speicherzellenanordnung in NAND-Struktur zum Speichern von Information und eine Referenzzellenanordnung zum Bereitstellen einer Referenzspannung aufweist, wobei die Leseverstärkerschaltung aufweist:

    ein Paar Bit-Leitungen mit einer ersten ($BL_i$) und einer zweiten ($BL_j$) Bit-Leitung, die an die Speicherzellenanordnung mit NAND-Struktur bzw. die Referenzzellenanordnung angeschlossen sind;

    ein Paar Sub-Bit-Leitungen mit einer ersten ($SBL_i$) und einer zweiten ($SBL_j$) Sub-Bit-Leitung entsprechend den jeweiligen Bit-Leitungen;

    eine die Bit-Leitungen trennende Einrichtung (12; 21) zum elektrischen und selektiven Trennen der Bit-Leitungen ($BL_{ij}$) von den Sub-Bit-Leitungen ($SBL_{ij}$) als Reaktion auf ein von außen zugeführtes Trenn-Steuersignal (ISO) während einer Aufladeperiode und einer Ausleseperiode;

    Einrichtungen (17; 18; 19; 20) zum Aufladen und Entzerren der Sub-Bit-Leitungen während einer Aufladeperiode;

    eine Signalleitung (VSA; $V_{san}$) zum Empfangen eines von außen zugeführten Spannungssignals;

    eine spannungsgesteuerte Stromquelle mit ersten und zweiten Strompfaden, die an die erste bzw. zweite Sub-Bit-Leitung angeschlossen sind, wobei ein über den zweiten Strompfad fließender Strom in Übereinstimmung mit einem Spannungspegel der ersten Bit-Leitung eingestellt wird und ein über den ersten Strompfad fließender Strom in Übereinstimmung mit einem Spannungspegel der zweiten Bit-Leitung eingestellt wird;

    eine Schalteinrichtung zum elektrischen und selektiven Anschließen wenigstens des ersten oder zweiten Strompfades an die Signalleitung als Reaktion auf ein Schalt-Steuersignal; und

    eine Verstärkereinrichtung zum Verstärken von Spannungspegeln der Sub-Bit-Leitungen auf einen ersten bzw. zweiten Spannungspegel, wenn eine Potentialdifferenz zwischen den Sub-Bit-Leitungen größer als eine vorgegebene Spannung ist.

2.  Nichtflüchtige Halbleiterspeichervorrichtung gemäß Anspruch 1, bei der die spannungsgesteuerte Stromquelle (13; 22) aufweist: einen ersten n-Kanal-MOS-Transistor (Q21; Q37) mit einem Source-Drain-Kanal, der an eine der Sub-Bit-Leitungen ($SBL_i$) angeschlossen ist, und einem Gate, dass an die andere der Bit-Leitungen ($BL_j$) angeschlossen ist, und einen zweiten n-Kanal-MOS-Transistor (Q22; Q38) mit einem Source-Drain-Kanal, der an die andere der Sub-Bit-Leitungen ($SBL_j$) angeschlossen ist, und einem Gate, das an die andere der Bit-Leitungen ($Bl_i$) angeschlossen ist.

3.  Nichtflüchtige Halbleiterspeichervorrichtung nach einem der Ansprüche 1 oder 2, bei der die Schalteinrichtung aufweist: einen ersten MOS-Transistor (Q23; Q39) mit einem Source-Drain-Kanal, der zwischen der Signalleitung und dem Source-Drain-Kanal des ersten n-Kanal-MOS-Transistors (Q21; Q37) angeschlossen ist, und einem Gate zum Empfangen des Schalt-Steuersignals ($\Phi SA$; $\Phi ISA_i$), und einen zweiten MOS-Transistor (Q24; Q40) mit einem Source-Drain-Kanal, der zwischen der Signalleitung und dem Source-Drain-Kanal des zweiten n-Kanal-MOS-Transistors (Q22; Q38) angeschlossen ist, und einem Gate zum Empfangen des Schalt-Steuersignals ($\Phi SA$; $\Phi ISA$).

4.  Nichtflüchtige Halbleiterspeichervorrichtung nach einem der vorangehenden Ansprüche, bei der das Schalt-Steuersignal ein Impulssignal mit einer Impulsdauer, die nach dem Beginn einer Ausleseoperation auftritt, ist.

5.  Nichtflüchtige Halbleiterspeichervorrichtung nach Anspruch 3 oder Anspruch 4, wenn dieser auf Anspruch 3 zurückbezogen ist, bei der die Verstärkereinrichtung aufweist: einen dritten n-Kanal-MOS-Transistor (Q25; Q41) mit einem Source-Drain-Kanal, der zwischen einer ersten Treiberleitung ($\overline{LA}$; $V_{sal}$) zum Empfangen eines ersten Treiberspannungssignals und der ersten Sub-Bit-Leitung ($SBL_i$) angeschlossen ist, und einem Gate, das an die zweite Sub-Bit-Leitung ($SBL_j$) angeschlossen ist, einen vierten n-Kanal-MOS-Transistor (Q26; Q42) mit einem Source-Drain-Kanal, der zwischen der ersten Treiberleitung ($\overline{LA}$; $V_{sal}$) und der zweiten Sub-Bit-Leitung ($SBL_j$) angeschlossen ist, und einem Gate, das an die erste Sub-Bit-Leitung ($SBL_i$) angeschlossen ist, einen ersten p-Kanal-MOS-Transistor (Q27; Q43) mit einem Source-Drain-Kanal, der zwischen einer zweiten Treiberleitung (LA; $V_{sah}$) zum Empfangen eines zweiten Treiberspannungssignals und der ersten Sub-Bit-Leitung ($SBL_i$)

angeschlossen ist, und einem Gate, das an die zweite Sub-Bit-Leitung (SBL$_j$) angeschlossen ist, und einen zweiten p-Kanal-MOS-Transistor (Q28; Q44) mit einem Source-Drain-Kanal, der zwischen der zweiten Treiberleitung (LA; V$_{sah}$) und der zweiten Sub-Bit-Leitung (SBL$_j$) angeschlossen ist, und einem Gate, das an die erste Sub-Bit-Leitung (SBL$_i$) angeschlossen ist.

6. Nichtflüchtige Halbleiterspeichervorrichtung nach einem der vorangehenden Ansprüche, bei welcher die Auflade- und Entzerreinrichtung eine Einrichtung zum Laden jeder Sub-Bit-Leitung auf einen Quellen-Spannungspegel aufweist.

7. Nichtflüchtige Halbleiterspeichervorrichtung nach einem der vorangehenden Ansprüche, bei der das von außen angelegte Spannungssignal während der Auflade- und Ausleseperiode auf einem Massespannungspegel gehalten wird.

8. Nichtflüchtige Halbleiterspeichervorrichtung nach Anspruch 5 oder Anspruch 6 oder 7, wenn diese auf Anspruch 5 zurückbezogen sind, bei der das erste Treiberspannungssignal während der Aufladeperiode auf einem Quellen-Spannungspegel und während der Ausleseperiode auf einem Massespannungspegel gehalten wird und bei der das zweite Treiberspannungssignal während der Lade- und Ausleseperiode auf dem Quellen-Spannungspegel gehalten wird.

9. Nichtflüchtige Halbleiterspeichervorrichtung nach einem der Ansprüche 1 bis 5, bei der die Auflade- und Entzerrereinrichtung eine Einrichtung zum Aufladen jeder der Sub-Bit-Leitungen auf den Massespannungspegel aufweist.

10. Nichtflüchtige Halbleiterspeichervorrichtung nach Anspruch 5 oder Anspruch 9, wenn dieser auf Anspruch 5 zurückbezogen ist, bei der das von außen zugeführte Spannungssignal während der Lade- und Ausleseperiode auf dem Quellen-Spannungspegel gehalten wird.

11. Nichtflüchtige Halbleiterspeichervorrichtung nach Anspruch 5 oder Anspruch 9 oder 10, wenn diese auf Anspruch 5 zurückbezogen sind, bei der das erste Treiberspannungssignal während der Auflade- und Ausleseperiode auf dem Massespannungspegel gehalten wird, und bei der das zweite Treibersignal während der Aufladeperiode auf dem Massespannungspegel und während der Ausleseperiode auf dem Quellen-Spannungspegel gehalten wird.

12. Nichtflüchtige Halbleiterspeichervorrichtung nach Anspruch 1, die weiterhin aufweist:

eine Einrichtung zum Laden und Entzerren der Bit-Leitungen während einer Aufladeperiode; und

eine Konstantspannungsquelle zum Bereitstellen eines konstanten Spannungssignals an die Signalleitung; wobei das Paar Sub-Bit-Leitungen (SBL$_{ij}$) durch von außen zugeführte Datensignale geladen werden; und

wobei die Schalteinrichtung den ersten und zweiten Strompfad an die Konstantspannungsquelle als Reaktion auf das erste (ΦISA$_i$) und zweite (ΦISA$_j$) Schalt-Steuersignal anschließt.

13. Nichtflüchtige Halbleiterspeichervorrichtung nach Anspruch 12, bei der das konstante Spannungssignal während der Auflade- und Ausleseperiode auf einem Massespannungspegel gehalten wird.

14. Nichtflüchtige Halbleiterspeichervorrichtung nach Anspruch 12 oder 13, bei der das erste Treiberspannungssignal während der Aufladeperiode auf einem Quellen-Spannungspegel und während der Ausleseperiode auf einem Massespannungspegel gehalten wird, und bei dem das zweite Treiberspannungssignal während der Aufladeperiode auf dem Massespannungspegel und während der Ausleseperiode auf dem Quellen-Spannungspegel gehalten wird.

15. Nichtflüchtige Halbleiterspeichervorrichtung nach einem der Ansprüche 12 bis 14, die weiterhin eine weitere spannungsgesteuerte Stromquelle aufweist, die dritte und vierte Strompfade aufweist, die in Reihe zwischen die Schalteinrichtung und die Konstantspannungsquelle und parallel zueinander geschaltet sind, zum Einstellen eines über den dritten Strompfad fließenden Stromes in Übereinstimmung mit einem Spannungspegel der einen der Bit-Leitungen während des Auslesevorgangs und zum Einstellen eines über den vierten Strompfad fließenden Stromes in Übereinstimmung mit einem Spannungspegel der anderen der Bit-Leitungen.

16. Nichtflüchtige Halbleiterspeichervorrichtung nach einem der Ansprüche 12 bis 15, bei der das erste und zweite Schalt-Steuersignal jeweils ein Impulssignal ist, das eine Impulsdauer aufweist, die zum Datenauslesen nach dem Beginn einer Ausleseoperation auftritt.

17. Nichtflüchtige Halbleiterspeichervorrichtung nach einem der Ansprüche 12 bis 16, bei der das erste Treiberspannungssignal während der Auflade- und Ausleseperiode zur Überprüfung der Programmierung und Verhinderung der Programmierung auf dem Massespannungspegel gehalten wird, und bei der das zweite Treiberspannungssignal während der Aufladeperiode auf dem Quellen-Spannungspegel gehalten wird.

18. Nichtflüchtige Halbleiterspeichervorrichtung nach Anspruch 15, bei der das erste Schalt-Steuersignal während der Lade- und Ausleseperiode zur Überprüfung der Programmierung und Verhinderung der Programmierung auf dem Massespannungspegel gehalten wird, und bei der das zweite Treiberspannungssignal ein Impulssignal ist, das eine Impulsdauer aufweist, die nach dem Beginn einer Ausleseoperation auftritt, um eine Programmierung zu überprüfen und zu verhindern.

19. Nichtflüchtige Halbleiterspeichervorrichtung nach Anspruch 12 oder einem darauf zurückbezogenen Anspruch, bei der die Einrichtung zum Trennen der Bit-Leitungen eine Einrichtung zum elektrischen Verbinden der einen der Bit-Leitungen, mit der einen der Sub-Bit-Leitungen als Reaktion auf die Aktivierung des zweiten Schalt-Steuersignals während eines Programmiervorgangs einer aktiven Zelle, die an die eine der Bit-Leitungen angeschlossen ist, aufweist.

**Revendications**

1. Dispositif de mémoire non volatile à semi-conducteurs ayant un circuit d'amplificateur de lecture et une matrice de cellules de mémoire à structure NON-ET pour le stockage d'informations et une matrice de cellules de référence pour produire une tension de référence, ledit circuit comportant:

une paire de lignes de bits comportant des première ($BL_i$) et seconde ($BL_j$) lignés de bits connectées à ladite matrice de cellules de mémoire à structure NON-ET et à ladite matrice de cellules de référence, respectivement;
une paire de lignes de sous-bits comprenant des première ($SBL_i$) et seconde ($SBL_j$) lignes de sous-bits correspondant auxdites lignes de bits, respectivement;
un moyen (12; 21) d'isolation de lignes de bits destiné à isoler électriquement et sélectivement lesdites lignes de bits ($BL_{ij}$) desdites lignes de sous-bits ($SBL_{ij}$) en réponse à un signal (ISO) dé commande d'isolation appliqué extérieurement pendant une période de précharge et une période de lecture;
un moyen (17; 18; 19; 20) destiné à précharger et égaliser lesdites lignes de sous-bits pendant une période de précharge;
une ligne de signal (VSA; $V_{san}$) destinée à recevoir un signal de tension appliqué extérieurement;

une source de courant commandée en tension ayant des premier et second chemins de courant connectés auxdites première et seconde lignes de sous-bits, respectivement, grâce à quoi une quantité de courant circulant dans ledit second chemin de courant est ajustée en fonction d'un niveau de tension de ladite première ligne de bits et une quantité de courant circulant dans ledit premier chemin de courant est ajustée en fonction d'un niveau de tension de ladite seconde ligne de bits;
un moyen de commutation destiné à connecter électriquement et sélectivement au moins l'un desdits premier et second chemins de courant à ladite ligne de signal en réponse à un signal de commande de commutation; et
un moyen à amplificateur destiné à amplifier des niveaux de tension desdites lignes de sous-bits à des premier et second niveaux de tension prédéterminés, respectivement, lorsqu'une différence de potentiel entre lesdites lignes de sous-bits est supérieure à une tension prédéterminée.

2. Dispositif de mémoire non volatile à semi-conducteurs selon la revendication 1, dans lequel ladite source de courant (13; 22) commandée en tension comporte un premier transistor (Q21; Q37) MOS à canal n ayant un canal source-drain connecté à l'une desdites lignes de sous-bits ($SBL_i$) et une grille connectée à l'autre desdites lignes de bits ($BL_j$), et un second transistor MOS (Q22, Q38) à canal n ayant un canal source-drain connecté à l'autre desdites lignes de sous-bits ($SBL_j$) et une grille connectée à l'autre desdites lignes de bits ($BL_i$).

3. Dispositif de mémoire non volatile à semi-conducteurs selon l'une quelconque des revendications 1 et 2, dans lequel ledit moyen de commutation comporte un premier transistor MOS (Q23; Q39) ayant un canal source-drain connecté entre ladite ligne de signal et ledit canal source-drain dudit premier transistor MOS (Q21; Q37) à canal n et une grille destinée à recevoir ledit signal de commande de commutation ($\phi SA$; $\phi ISA_i$), et un second transistor MOS (Q24; Q40) ayant un canal source-drain connecté entre ladite ligne de signal et ledit canal source-drain dudit second transistor MOS (Q22; Q38) à canal n et une grille destinée à recevoir ledit signal de commande de commutation ($\phi SA$; $\phi ISA$).

4. Dispositif de mémoire non volatile à semi-conducteurs selon l'une quelconque des revendications précédentes, dans lequel ledit signal de commande de commutation est un signal à impulsions ayant une durée d'impulsion apparaissant après le commencement d'une opération de lecture.

5. Dispositif de mémoire non volatile à semi-conducteurs selon la revendication 3 ou la revendication 4 lorsqu'elle dépend de la revendication 3, dans lequel ledit moyen à amplificateur comporte un troisième transistor MOS (Q25; Q41) à canal n ayant un canal source-drain connecté entre une première ligne d'attaque ($\overline{LA}$; $V_{sal}$) destinée à recevoir un premier signal de tension d'attaque et la première ligne de sous-bits (SBL$_i$) et une grille connectée à ladite seconde ligne de sous-bits (SBL$_j$), un quatrième transistor MOS (Q26; Q42) à canal n ayant un canal source-drain connecté entre la première ligne d'attaque ($\overline{LA}$; $V_{sal}$) et ladite seconde ligne de sous-bits (SBL$_j$) et une grille connectée à ladite première ligne de sous-bits (SBL$_i$), un premier transistor MOS (Q27; Q43) à canal p ayant un canal source-drain connecté entre une seconde ligne d'attaque (LA; $V_{sah}$) destinée à recevoir un second signal de tension d'attaque et ladite première ligne de sous-bits (SBL$_i$) et une grille connectée à ladite seconde ligne de sous-bits (SBL$_j$) et un second transistor MOS (Q28, Q44) à canal p ayant un canal source-drain connecté entre ladite seconde ligne d'attaque (LA; $V_{sah}$) et ladite seconde ligne de sous-bits (SBL$_j$) et une grille connectée à ladite première ligne de sous-bits (SBL$_i$).

6. Dispositif de mémoire non volatile à semi-conducteurs selon l'une quelconque des revendications précédentes, dans lequel ledit moyen de précharge et d'égalisation comporte un moyen destiné à précharger chacune desdits lignes de sous-bits à un niveau de tension de source.

7. Dispositif de mémoire non volatile à semi-conducteurs selon l'une quelconque des revendications précédentes, dans lequel ledit signal de tension appliqué extérieurement est maintenu à un niveau de tension de masse pendant ladite période de précharge et de lecture.

8. Dispositif de mémoire non volatile à semi-conducteurs selon la revendication 5 ou la revendication 6 ou 7 lorsqu'elle dépend de la revendication 5, dans lequel ledit premier signal de tension d'attaque est maintenu à un niveau de tension de source pendant ladite période de précharge et à un niveau de tension de masse pendant ladite période de lecture, et dans lequel ledit second signal de tension d'attaque est maintenu audit niveau de tension de source pendant ladite période de précharge et de lecture.

9. Dispositif de mémoire non volatile à semi-conducteurs selon l'une quelconque des revendications 1 à 5, dans lequel ledit moyen de précharge et d'égalisation comporte un moyen destiné à précharger chacune desdites lignes de sous-bits audit niveau de tension de masse.

10. Dispositif de mémoire non volatile à semi-conducteurs selon la revendication 5 ou la revendication 9 lorsqu'elle dépend de la revendication 5, dans lequel ledit signal de tension appliqué extérieurement est maintenu audit niveau de tension de source pendant ladite période de précharge et de lecture.

11. Dispositif de mémoire non volatile à semi-conducteurs selon la revendication 5, ou la revendication 9 ou 10 lorsqu'elle dépend de la revendication 5, dans lequel ledit premier signal de tension d'attaque est maintenu audit niveau de tension de masse pendant ladite période de précharge et de lecture, ledit second signal de tension d'attaque est maintenu audit niveau de tension de masse pendant ladite période de précharge et audit niveau de tension de source pendant ladite période de lecture.

12. Dispositif de mémoire non volatile à semi-conducteurs selon la revendication 1, comportant en outre:

   un moyen destiné à précharger et égaliser lesdites lignes de bits pendant une période de précharge; et
   une source de tension constante destinée à appliquer à la ligne de signal un signal de tension constante; grâce à quoi la paire de lignes de sous-bits (SBL$_{ij}$) est préchargée par des signaux de données appliqués extérieurement; et
   le moyen de commutation connecte lesdits premier et second chemins de courant à ladite source de tension constante en réponse à des premier ($\phi$ISA$_i$) et second ($\phi$ISA$_j$) signaux de commande de commutation, respectivement.

13. Dispositif de mémoire non volatile à semi-conducteurs selon la revendication 12, dans lequel le signal de tension constante est maintenu à un niveau de tension de masse pendant la période de précharge et de lecture.

14. Dispositif de mémoire non volatile à semi-conducteurs selon la revendication 12 ou la revendication 13, dans lequel le premier signal de tension d'attaque est maintenu à un niveau de tension de source pendant la période de précharge et à un niveau de tension de masse pendant la période de lecture, et dans lequel le second signal de tension d'attaque est maintenu au niveau de tension de masse pendant la période de précharge et au niveau de tension de source pendant la période de lecture.

15. Dispositif de mémoire non volatile à semi-conducteurs selon l'une quelconque des revendications 12 à 14, comportant en outre une autre source de courant commandée en tension ayant des troisième et quatrième chemins de courant connectés en série entre ledit moyen de commutation et ladite source de tension constante et en parallèle entre eux, pour ajuster une quantité de courant circulant dans ledit troisième chemin de courant en fonction d'un niveau de tension de l'une desdites lignes de bits pendant la période de lecture et ajuster une quantité de courant circulant dans ledit quatrième chemin de courant en fonction d'un niveau de tension de l'autre desdites lignes de bits.

16. Dispositif de mémoire non volatile à semi-conducteurs selon l'une quelconque des revendications 12 à 15, dans lequel chacun des premier et second signaux de commande de commutation est un signal à impulsions ayant une durée d'impulsion apparaissant après le commencement d'une opération de lecture pour l'extraction de données.

17. Dispositif de mémoire non volatile à semi-conducteurs selon l'une quelconque des revendications 12 à 16, dans lequel le premier signal de tension d'attaque est maintenu au niveau de tension de masse pendant la période de précharge et de lecture pour une vérification et une inhibition de programme, et le second signal de tension d'attaque est maintenu au niveau de tension de source pendant la période de précharge.

18. Dispositif de mémoire non volatile à semi-conducteurs selon la revendication 15, dans lequel le premier signal de commande de commutation est maintenu au niveau de tension de masse pendant la période de précharge et de lecture pour une vérification et une inhibition de programme, et le second signal de tension d'attaque est un signal à impulsions ayant une durée d'impulsion apparaissant après le commencement d'une opération de lecture pour une vérification et une inhibition de programme.

19. Dispositif de mémoire non volatile à semi-conducteurs selon la revendication 12 ou l'une quelconque des revendications qui en dépendent, dans lequel le moyen d'isolation de lignes de bits comprend un moyen destiné à connecter électriquement l'une desdites lignes de bits à l'une desdites lignes de sous-bits en réponse à l'activation du second signal de commande de commutation pendant une opération de programmation d'une cellule en circuit connectée à l'une desdites lignes de bits.

# Fig. 1

Prior Art

# Fig. 2

Prior Art

# Fig. 3

Prior Art

# Fig. 4

Prior Art

øBL

WL

ISOi

ISOj

Vsah — High

Vsal

BLi,j — BLi(off-cell)
BLj(reference cell)
BLi(on-cell)

Sensing Start

# Fig. 5

Prior Art

øBL

WL

ISOi

ISOj

Vsah — High

Vsal

BLi,j
(on-cell program) — BLi(off-cell)
BLj(reference cell)
BLi(on-cell)

BLi,j
(on-cell inhibit) — BLi(off-cell)

BLi(on-cell)

BLj(reference cell)

Sensing Start

EP 0 758 127 B1

# Fig. 6

EP 0 758 127 B1

## Fig. 7

## Fig. 8

20

# Fig. 9

# Fig. 10

# Fig.11

# Fig.12

| | | |
|---|---|---|
| WL | | |
| ISOi,j | | Low |
| øSAi | | |
| øSAj | | |
| Vsah | | High |
| Vsal | | Low |
| BLi,j | | BLi(off—cell) |
| | | BLj(reference cell) |
| | | BLi(on—cell) |

Sensing Start

# Fig.13

| | | |
|---|---|---|
| WL | | |
| ISOi,j | | Low |
| øSAi | | Low |
| øSAj | | |
| Vsah | | High |
| Vsal | | Low |
| BLi,j | | BLi(off—cell) |
| | | BLj(reference cell) |
| | | BLi(on—cell) |

Sensing Start

SBLi,j
(on—cell program)

SBLi,j
(on—cell inhibit) — High

23

# Fig.14

# Fig.15

WL

ISOi,j — Low

øSAi

Vsan — Low

Vsah — High

Vsal — Low

BLi,j — BLi(off-cell)
BLj(reference cell)
BLi(on-cell)

Sensing Start

# Fig.16

WL

ISOi,j — Low

øSAj

Vsan — $\geq$(Vref−Vtn)

Vsah — High

Vsal — Low

BLi,j — BLi(off-cell)
BLj(reference cell)
BLi(on-cell)

Sensing Start

SBLi,j
(on-cell program)

SBLi,j — High
(on-cell inhibit)